# EUROPEAN PATENT SPECIFICATION

(11) **EP 0 308 576 B1**
(45) Date of publication and mention of the grant of the patent: **13.07.1994**
(21) Application number: 88105342.5
(22) Date of filing: 02.04.1988
(51) Int. Cl.: H05K 1/00, H05K 7/20

(54) **A printed wiring board**
Leiterplatte
Plaque à circuit imprimé

(30) Priority: 19.09.1987 JP 235762/87; 19.09.1987 JP 235763/87; 19.09.1987 JP 235764/87
(43) Date of publication of application: 29.03.1989
(73) Proprietor: Nippon CMK Corp., Iruma-Gun Saitama (JP)
(72) Inventor: Kawakami, Shin, Higashimatsuyama-shi Saitama (JP); Haruyama, Satoshi, Fujioka-shi Gunma (JP); Okonogi, Hirotaka, Isezaki-shi Gunma (JP); Nikaido, Katsutomo, Isezaki-shi Gunma (JP); Mukai, Norito, Ohta-Ku Tokyo (JP)
(74) Representative: Schickedanz, Willi, Dipl.-Ing.

(56) References cited:
- FR-A- 2 480 488
- NEW ELECTRONICS, vol. 17, no. 13, June 1984, page 76, Warley, West Midlands, GB; M. BOWREY: "Silicon Conformal Coatings for the Protection of PCBS"

## Description

### Technical Field to which the Invention relates

The present invention relates to a printed wiring board.

### Description of the Prior Art

Conventional printed wiring boards are produced by etching a copper film on a copper clad laminated plate, so as to form desired circuit conductors on the upper surface of a base plate.

On the circuit conductor of the printed wiring board an overcoat by an insulating film is formed.

### Disadvantages of the Prior Art

Such conventional printed wiring board of the above described construction includes disadvantage such that heat produced during operation of the circuit conductor cannot sufficiently dissipate owing to the insulating film which acts as effective electrical and thermal insulation to the circuit conductor. Consequently, the circuit conductor may be overheated to cause erroneous operation or short service life.

### Technical Problem

The object of the present invention is to eliminate or at least mitigate the above mentioned disadvantage and to provide an improved printed wiring board which effectively prevents the circuit conductor from overheating.

### Solution of the Technical Problem

A radiating film covers at least a portion of the outer surface of the circuit conductor.

Preferably, the radiating film is formed by attaching heat radiating paste on the surface of the circuit conductor.

Preferably, the radiating film covers at least a portion of width of the circuit conductor.

Preferably, the radiating film is formed on the surface of the circuit conductor by painting heat radiating paste formed by metal as copper or nickel or by non-organic material as ceramics of aluminium oxide by painting means as silk screen printing process and hardened.

### Advantageous Effects of the Invention

The printed wiring board, according to the present invention, performs positive heat dissipating effect by the radiating film formed on at least a portion of the surface of the circuit conductor so that heat produced in the circuit conductor while operation of the printed wiring board can be dissipated effectively. Further, by forming heat dissipating window through the insulating film covering the circuit conductor, heat dissipating effect is more effectively performed to prevent overheat or erroneous operation.

### Brief Description of the Drawings

Figure 1 is an enlarged plan view of a portion of a printed wiring board according to a first embodiment of the present invention.

Figure 2 is an enlarged sectional view of a portion of a printed wiring board according to a first embodiment of the present invention.

Figure 3 is an enlarged plan view of a portion of a printed wiring board according to a second embodiment.

Figure 4 is an enlarged sectional view of a portion of a printed wiring board according to a second embodiment.

Figure 5 is an enlarged plan view of a portion of a printed wiring board according to a third embodiment of the present invention.

Figure 6 is an enlarged sectional view of a portion of a printed wiring board according to a third embodiment of the present invention.

Figure 7 is an enlarged sectional view of a portion of a conventional printed wiring board.

### Detailed Description of the Prior Art and of the Preferred Embodiments

Fig. 7 shows a conventional printed wiring board 5 which is produced by etching a copper film 2 on a copper clad laminated plate 1 so as to form desired circuit conductors 3 on the upper surface of a base plate 4. On the circuit conductor 3 of the printed wiring board 5 an overcoat by an insulating film 6 is formed. The disadvantages of this structure have been disclosed above.

Now, some preferred embodiments of the printed wiring board according to the present invention will be described referring to the drawings. In the drawings, the same reference numeral shows the same or a similar part or a portion thereof for sake of clarity.

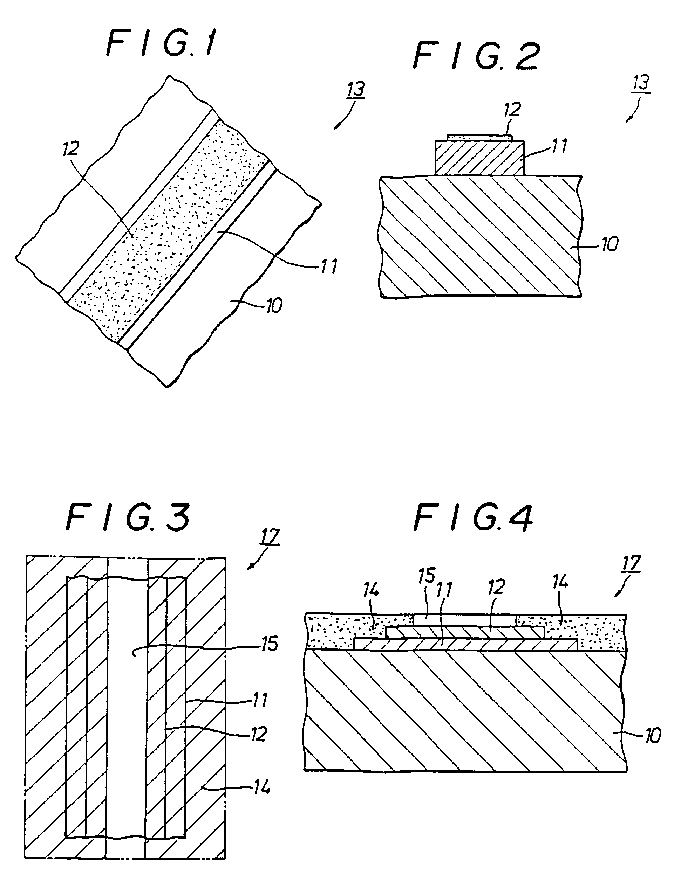

Referring to Figs. 1 and 2 which show a first embodiment of the present invention, a base 10 and a circuit conductor 11 formed on one surface of the base plate 10 are shown. On the surface of the circuit conductor 11 a heat radiation film 12 is attached. The radiation film 12 is formed by painting radiation paste by means e.g. silk screen printing process while producing the printed wiring board, and the paste is hardened. The radiation paste is composed mainly of metal e.g. copper or nickel, or non-organic material e.g. ceramics such as aluminium oxide.

In the illustrated embodiment, a printed wiring board forming circuit conductor 11 on one surface of the base plate 10 is shown. However, the radiation film 12 can be applied to other circuit conductors formed on both surfaces of the baseplate or formed as multi-layers conductors.

The illustrated radiation film 12 is narrower than the width of the circuit conductor 11. However, the radiation film 12 may have the same width as the circuit conductor 11. The radiation film 12 may extend to full length of necessary circuit conductor, or may extend on one or more portions of the circuit conductors as necessary.

In the illustrated embodiment, other construction of the printed wiring board, e.g. insulating film 6 shown in Fig. 7 is not shown. However, such construction may be added when necessary.

If an insulating film is formed on the circuit conductor 11, the printed wiring board 13 shown in Figs. 1 and 2 positively dissipates heat produced in the circuit conductor 11 owing to the radiation film 12 formed on the circuit conductor 11 so that erroneous operation by overheat is eliminated, and also, heat resistance property of the circuit conductor 11 is improved by the radiation film 12.

A second embodiment of a printed wiring board is shown in Figs. 3 and 4. As before, on the base plate 10, the radiation film 12 is formed on the conductor 11. The circuit conductor 11 may be formed on one or both surfaces of the base plate 10. The radiation film 12 may be smaller than or have the same width as the circuit conductor 11.

Further, an insulating film 14 is formed on the circuit conductor 11 as usual, and a heat dissipating window 15 formed as a slot along a necessary portion or necessary portions of the radiation film 12 is formed through the insulating film 14.

The above described printed wiring board 17 according to the second embodiment of the present invention positively dissipates heat produced in the circuit conductor 11 by the radiation film 12 applied on the conductor 11, and further, as the radiation film 12 is exposed outside by the heat dissipating window 15, heat dissipating property of the radiation film 12 is substantially increased. Consequently, erroneous operation of the printed wiring board 17 owing to overheat of the circuit conductor 11 by the heat produced in the conductor during operation is effectively eliminated. Further, heat resistance property of the circuit conductor 11 is improved by the radiation film 12.

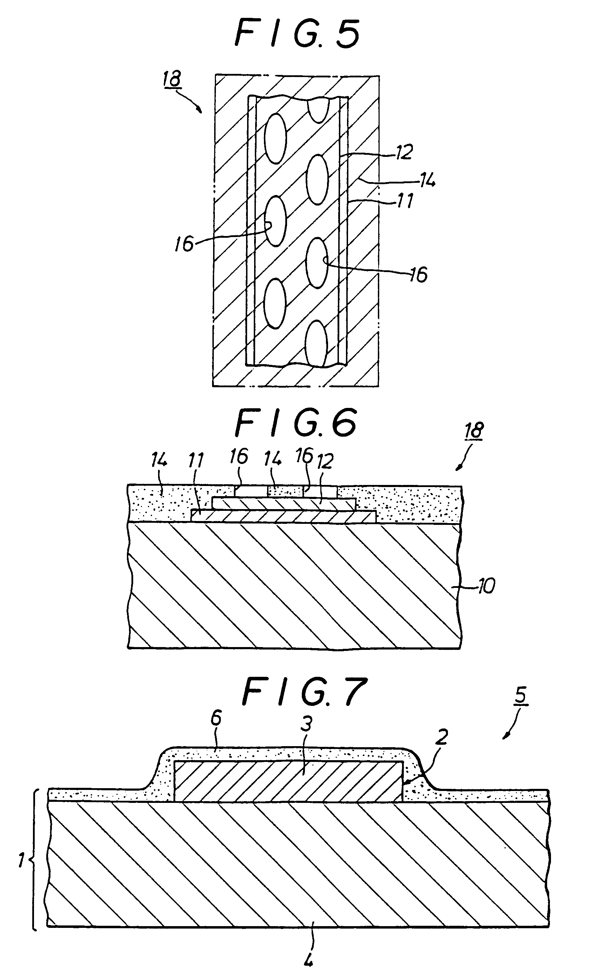

A third embodiment of a printed wiring board is shown in Figs. 5 and 6. As before, on the base plate 10 the circuit conductor 11 is formed and the radiation film 12 is formed on the conductor 11. The circuit conductor 11 may be formed on one or both surfaces of the base plate 10. The radiation film 12 may be narrow or have the same width as the circuit conductor 11.

Further, an insulating film 14 is formed on the circuit conductor 11 as usual, and a plurality of heat dissipating windows 16 having a generally circular or oval circumference and being arranged in a relatively spaced relation along a necessary portion or necessary portions of the radiation film 12, are formed through the insulating film 14. The number, size and relative space of the heat dissipating windows 16 can be selected as desired considering the heat produced in the circuit conductor 12 at specific portions.

According to the third embodiment of the present invention the above described printed wiring board 18 positively dissipates heat produced in the circuit conductor 11 by the radiation film 12 applied on the conductor 11, and further, as the radiation film 12 is exposed to heat dissipating windows 16, heat dissipating property of the radiation film 12 is substantially increased. Therefore, erroneous operation of the printed wiring board 18 owing to overheat of the circuit conductor 11 by the heat produced in the conductor during operation is effectively eliminated. Further, heat resistance property of the circuit conductor 11 is improved by the radiation film 12.

As the heat dissipating windows 16 do not impair lateral and longitudinal continuity of the insulation film 14, adhering strength and durability of the insulation film 14 are not decreased as compared with the slot like window 15 shown in Figs. 3 and 4.

As described, according to the present invention, the printed wiring board effectively improves heat dissipating property of the circuit conductor during operation so that erroneous operation owing to overheat of the circuit conductor by the heat produced in the conductor is decreased and heat resistivity of the circuit conductor is improved so that accuracy and service life of the printed wiring board are improved.

## Claims

1. A printed wiring board (13, 17, 18) which forms circuit conductors (11) on at least one surface of a base plate (10), **characterized in that** a heat radiating film (12) covers at least a portion of the outer surface of said circuit conductors (11), said heat radiating film (12) being of a material which is sufficiently thermally conducting so that the heat produced in the circuit conductors (11) during the use of the printed wiring board is effectively dissipated.

2. A printed wiring board according to claim 1, **characterized in that** said heat radiating film (12) is formed by attaching heat radiating paste on the surface of said circuit conductors (11).

3. A printed wiring board according to claim 1, **characterized in that** said heat radiating film (12) covers at least a portion of the width of said circuit conductors (11).

4. A printed wiring board according to claim 1, **characterized in that** said heat radiating film (12) is formed on the surface of the circuit conductors (11) by painting heat radiating paste consisting of metal as copper or nickel or of non-organic material as ceramics or aluminium oxide, said painting being carried out by a silk screen printing process.

5. A printed wiring board according to claim 1, **characterized in that** said heat radiating film (12) is applied on at least a portion of the surfaces of said circuit conductors (11) and that an insulation film (14) is applied on the circuit conductors (11), whereby slot-like heat dissipating windows (16) are formed on and along the radiating film (12).

6. A printed wiring board according to claim 1, **characterized in that** said heat radiating film (12) is applied on at least a portion of the surface of said circuit conductors (11), and that an insulation film (14) is applied on said circuit conductors (11), whereby a plurality of spaced heat dissipating windows (16) are formed on and along the radiating film (12).

7. A printed wiring board according to claim 5 or 6, **characterized in that** said heat radiating film (12) is formed by attaching heat radiating paste on the surface of said circuit conductors (11).

8. A printed wiring board according to claim 5 or 6, **characterized in that** said heat radiating film (12) covers at least a portion of the width of the circuit conductors (11).

9. A printed wiring board according to claim 5 or 6, **characterized in that** said heat radiating film (12) is formed on the surface of said circuit conductors (11) by painting heat radiating paste consisting of metal as copper or nickel or of non-organic material as ceramics or aluminium oxide, and that said painting means are printed by a silk screen printing process and then hardened.

## Patentansprüche

1. Gedruckte Leiterplatte (13, 17, 18), die Stromleiter (11) auf mindestens einer Oberfläche einer Grundplatte (10) aufweist, **dadurch gekennzeichnet,** daß ein warmeabstrahlender Film (12) mindestens einen Teil der äußeren Fläche der Stromleiter (11) bedeckt, wobei der wärmeabstrahlende Film (12) aus einem Material besteht, das ausreichend wärmeleitend ist, so daß die in den Stromleitern (11) entstehende Wärme während des Gebrauchs der gedruckten Leiterplatte wirksam abgegeben wird.

2. Gedruckte Leiterplatte nach Anspruch 1, **dadurch gekennzeichnet,** daß der wärmeabstrahlende Film (12) dadurch aufgebracht wird, daß eine wärmeabstrahlende Paste auf der Oberfläche der Stromleiter (11) aufgebracht wird.

3. Gedruckte Leiterplatte nach Anspruch 1, **dadurch gekennzeichnet,** daß der wärmeabstrahlende Film (12) mindestens einen Teil der Breite der Stromleiter (11) bedeckt.

4. Gedruckte Leiterplatte nach Anspruch 1, **dadurch gekennzeichnet,** daß der wärmeabstrahlende Film (12) dadurch auf die Oberfläche der Stromleiter (11) aufgebracht wird, daß ein Überzug aus einer wärmeabstrahlenden Paste aufgebracht wird, die aus Metall, wie Kupfer oder Nickel, oder einem nicht-organischen Material, wie Keramik oder Aluminiumoxid, besteht, wobei der Überzug durch ein Siebdruckverfahren aufgebracht wird.

5. Gedruckte Leiterplatte nach Anspruch 1, **dadurch gekennzeichnet,** daß der wärmeabstrahlende Film (12) auf mindestens einen Teil der Oberflächen der Stromleiter (11) aufgebracht wird und daß ein isolierender Film (14) auf die Stromleiter (11) aufgebracht wird, wobei schlitzförmige wärmeabgebende Fenster (16) in und entlang dem abstrahlenden Film (12) angebracht sind.

6. Gedruckte Leiterplatte nach Anspruch 1, **dadurch gekennzeichnet,** daß der wärmeabstrahlende Film (12) auf mindestens einem Teil der Oberfläche der Stromleiter (11) aufgebracht wird und daß ein isolierender Film (14) auf den Stromleitern (11) aufgebracht wird, wobei mehrere wärmeabgebende Fenster (16) mit Abstand zueinander in und entlang dem abstrahlenden Film (12) angebracht sind.

7. Gedruckte Leiterplatte nach Anspruch 5 oder 6, **dadurch gekennzeichnet,** daß der wärmeabstrahlende Film (12) dadurch aufgebracht wird, daß eine wärmeabstrahlende Paste auf der Oberfläche der Stromleiter (11) aufgebracht wird.

8. Gedruckte Leiterplatte nach Anspruch 5 oder 6, **dadurch gekennzeichnet,** daß der wärmeabstrahlende Film (12) mindestens einen Teil der Breite der Stromleiter (11) bedeckt.

9. Gedruckte Leiterplatte nach Anspruch 5 oder 6, **dadurch gekennzeichnet,** daß der wärmeabstrahlende Film (12) dadurch auf die Oberfläche der Stromleiter (11) aufgebracht wird, daß ein Überzug aus einer wärmeabstrahlenden Paste aufgebracht wird, die aus Metall, wie Kupfer oder Nickel, oder einem nicht-organischen Material, wie Keramik oder Aluminiumoxid, besteht, und daß der Überzug durch ein Siebdruckverfahren aufgebracht und dann gehärtet wird.

## Revendications

1. Carte à circuits imprimés (13,17,18) qui forme des conducteurs de circuit (11) sur au moins une surface d'une plaque de base (10), caractérisée en ce qu'une pellicule de rayonnement thermique (12) recouvre au moins une partie de la surface externe des conducteurs de circuit (11), la pellicule de rayonnement thermique (12) étant composée d'un matériau qui est suffisamment conducteur thermiquement pour que la chaleur produite dans les conducteurs de circuit (11) pendant l'utilisation de la carte à circuits imprimés soit efficacement dissipée.

2. Carte à circuits imprimés selon la revendication 1, caractérisée en ce que la pellicule de rayonnement thermique (12) est formée en collant une pâte de rayonnement thermique à la surface des conducteurs de circuit (11).

3. Carte à circuits imprimés selon la revendication 1, caractérisée en ce que la pellicule de rayonnement thermique (12) recouvre au moins une partie de la largeur des conducteurs de circuit (11).

4. Carte à circuits imprimés selon la revendication 1, caractérisée en ce que la pellicule de rayonnement thermique (12) est formée à la surface de conducteurs de circuit (11) par enduction d'une pâte de rayonnement thermique composée de métal tel que le cuivre ou le nickel ou d'un matériau inorganique tel que la céramique ou l'oxyde d'aluminium, l'opération d'enduction étant effectuée par un procédé de sérigraphie.

5. Carte à circuits imprimés selon la revendication 1, caractérisée en ce que la pellicule de rayonnement thermique (12) est appliquée sur au moins une partie des surfaces des conducteurs de circuit (11) et en ce qu'une pellicule d'isolation (14) est appliquée sur les conducteurs de circuit (11), les fenêtres de dissipation thermique (16) en forme de fentes étant pratiquées dans et le long de la pellicule de rayonnement (12).

6. Carte à circuits imprimés selon la revendication 1, caractérisée en ce que la pellicule de rayonnement thermique (12) est appliquée sur au moins une partie de la surface des conducteurs de circuit (11) et en ce qu'une pellicule d'isolation (14) est appliquée sur les conducteurs de circuit (11), plusieurs fenêtres de dissipation thermique espacées (16) étant pratiquées dans et le long de la pellicule de rayonnement (12).

7. Carte à circuits imprimés selon la revendication 5 ou 6, caractérisée en ce que la pellicule de rayonnement thermique (12) est formée en collant une pâte de rayonnement thermique à la surface des conducteurs de circuit (11).

8. Carte à circuits imprimés selon la revendication 5 ou 6, caractérisée en ce que la pellicule de rayonnement thermique (12) recouvre au moins une partie de la largeur des conducteurs de circuit (11).

9. Carte à circuits imprimés selon la revendication 5 ou 6, caractérisée en ce que la pellicule de rayonnement thermique (12) est formée à la surface des conducteurs de circuit (11) par enduction d'une pâte de rayonnement thermique composée de métal tel que le cuivre et le nickel ou d'un matériau inorganique tel que la céramique ou l'oxyde d'aluminium et en ce que le moyen d'enduction est appliqué par un procédé de sérigraphie et ensuite durci.
